Europäisches Patentamt

European Patent Office

Office européen des brevets

(11) Publication number: **0 374 876**
**A2**

## EUROPEAN PATENT APPLICATION

(21) Application number: **89123541.8**

(51) Int. Cl.5 **G03F 7/16, H01K 1/00**

(22) Date of filing: **20.12.89**

(30) Priority: **23.12.88 US 289149**

(43) Date of publication of application:
**27.06.90 Bulletin 90/26**

(84) Designated Contracting States:
**CH DE FR GB IT LI NL SE**

(71) Applicant: **E.I. DU PONT DE NEMOURS AND COMPANY**
**1007 Market Street**
**Wilmington Delaware 19898(US)**

(72) Inventor: **Stout, Gary Karl**
**927 Paul Street**
**Gloucester New Jersey 08030(US)**

(74) Representative: **Werner, Hans-Karsten, Dr. et al**
**Deichmannhaus am Hauptbahnhof**
**D-5000 Köln 1(DE)**

(54) **Bubble free liquid solder mask-coated printed circuit boards by fluid pressurizing.**

(57) A method is disclosed of obtaining a bubble free photosensitive liquid layer and an interface with a substrate by applying uniform fluid pressure after coating the liquid on the substrate.

EP 0 374 876 A2

## BUBBLE FREE LIQUID SOLDER MASK-COATED PRINTED CIRCUIT BOARDS BY FLUID PRESSURIZING

### Background of the Invention

The present invention is directed to a method of obtaining a substantially bubble free interface between a substrate surface and a liquid photopolymerizable layer applied thereto. More specifically the present invention is particularly adapted to application of a soldermask in the manufacture of a printed circuit board.

Photocurable liquid layers are conventionally applied to substrate surfaces in the manufacture of circuit boards and other electronic components as for instance disclosed in Chapter 6 of Printed Circuits Handbook, Second Edition, edited by C.F. Coombs, Jr. In a typical application, photocurable liquid resist is screen printed onto a substrate using a stencil screen with an image of the desired circuit pattern to produce on the substrate a printed circuit pattern which is then photocured and further processed to give a printed circuit. Alternately, a photocurable liquid may be uniformly applied to a substrate, such as by spin coating, curtain coating, screen coating, etc., and then imagewise exposed to curing, actinic radiation and further processed to produce a printed circuit pattern on a substrate surface. The photocurable material may be applied as a solution or it may be applied as a solvent-free neat liquid. In either case there exists an opportunity for entrapping air or voids during the application process.

Losert et al. U.S. Patent 4,230,793 discloses a curtain coating process for applying photocurable soldermask solutions to circuit board substrates, removing the solvent and then imaging and processing the solvent free layer to produce a solder resistant encapsulating mask on the circuit board.

Sullivan U.S. Patents 4,506,004 & 4,591,265 disclose a photoimaging system wherein a neat photopolymerizable liquid is screen coated onto a photomask and circuit board substrate, the coatings mated and imagewise photocured and then further processed to produce soldermasked circuit boards.

Heiart U.S. Patent 4,548,884 discloses the application of photopolymerizable liquid between the substrate and a photomask during contact imaging to produce a soldermask image on the circuit board substrate after further processing.

Oizuma et al. U.S. Patent 4,388,129 discloses a method for impregnating a porous fibrous substrate with a solvent-free liquid resin, allowing substantially all entrapped air bubbles to disappear by dissolving into the liquid resin and curing the combination. The air bubbles can be eliminated by standing for a sufficient period of time which may be shortened by applying ultrasonic waves, by placing the green laminate in compressed air or by using degassed liquid resin.

### Summary of the Invention

The present invention is directed to a method of obtaining a substantially bubble free photosensitive liquid layer on a substrate comprising the steps of (a) applying at least one photosensitive liquid layer to a surface of the substrate to form a coated substrate (b) applying elevated pressure of at least 0.3 atmospheres (about 5 psi) above ambient uniformly to the coated substrate by a pressurized fluid whereby any bubbles or voids entrapped in the liquid layer are eliminated; and (c) releasing the elevated pressure.

### Detailed Description of the Invention

The present invention is considered to be an improved method over prior art photosensitive liquid coating processes wherein a substrate is coated with a photosensitive liquid, a photomask or phototool is aligned with the substrate either in contact with the liquid or off-contact above the liquid and the liquid imagewise exposed by actinic light passing through the photomask. Instead of the use of a photomask or phototool, the coated substrate may be imagewise exposed using a projection imaging method or a scanned laser beam or some other form of scanned actinic radiation. Regardless of the method of exposure and further processing to form a stencil resist image, the coated substrates are first subjected to a fluid pressure in accordance to the process of this invention to eliminate unwanted microbubbles and/or voids in the coated photosensitive layer and its interface with the substrate and/or photomask or protective coversheet if present. While liquids which are inert to the photosensitive layer may be used as the pressurizing fluid when the surface of the photosensitive layer is unprotected, typically a gaseous fluid such as air, nitrogen or the like is used. The uniform fluid pressurization process of this invention may be further described in connection with the contact exposure process disclosed in Heiart U.S. Patent 4,548,884 which is incorporated by reference herein. Accordingly various portions of the patent are reproduced herein.

The sheet substrates which are to be coated, pressurized and imaged according to the teachings of the present invention are varied and depend on the utility of the final article. The substrate may be rigid or flexible, rough or smooth, homogeneous or nonhomogeneous, electrically conductive or nonconductive. The substrate may be coated with photosensitive liquid and imaged on one or both sides and the substrate surface may itself be photosensitive prior to application of the photosensitive liquid.

In the process of Heiart's invention either one or a number of sheet substrates are introduced into a registration and exposure device. The registration portion of the apparatus allows registration of the substrate, generally rectangular, to a photomask in a precise alignment. The photomask allows imagewise exposure of a photosensitive layer to actinic radiation.

The photomask, also known as a phototool, is a flexible sheet which allows actinic radiation to pass. Either one or two photomasks can be used since both sides of the sheet substrate may be imaged in sequence or simultaneously. With two photomasks a leading edge of each can be joined in a parallel, hinged relationship on each side of a thin carrier whose thickness approximates the thickness of the substrate. The photomasks can be maintained in precise register with each other by virtue of their hinged relationship to the common carrier.

With use of two photomasks the substrate is positioned or aligned between the photomask so the substrate is in registration with at least one photomask. Registration contact can be simple edge-to-edge contact of the substrate with a carrier wherein the only added criterion is that the desired image pattern of the photomask is completely contained within the area of the sheet to be imaged. However, registration more generally requires the precise alignment of details contained on the substrate with details of the photomask image or images. In this instance at least two contact points on or in the sheet are brought into a fixed relationship with two corresponding contact points fixed to the carrier. Such points may be notches and tabs suitably spaced on the sheet and carrier edges. Alternatively the points may consist of registration pin and hole combinations wherein the sheet contains precision drilled registration holes which are positioned in the desired orientation by registration pins. With use of a number of substrates the registration is identical from substrate to substrate to obtain a number of substantially identically exposed photosensitive layers on the substrates for subsequent processing.

Once the substrate is in registration relationship to the carrier, the flexible film photomask is applied to at least one side of the substrate in the presence of a photosensitive liquid interlayer by applying normal pressure in a line roughly parallel to the carrier on the outer surfaces of the photomasks at or near the hinged edges and advancing (relatively) the pressure line in the direction perpendicular to the hinge line and parallel to the substrate surface and, concurrent with the advance, applying the photosensitive liquid, e.g., by coating, to the substrate and/or the inner surface of the photomask. In effect the nip between the substrate and photomask formed by the advancing linear pressure acts to calender or form a photosensitive interlayer and the photomask is temporarily adhered to the photosensitive interlayer to give a registered sandwich structure in which a photosensitive layer separates a substrate surface and photomask. With application of photosensitive liquid on each of the two surfaces of the substrate, this lamination or calendering process step is preferably carried out by passing a hinged photomask-registered sheet assembly through a pair of pressure rollers. The nip pressure is adjusted according to the viscosity of the liquid, the rate of passage of the substrate through the nip, and the layer thickness desired. In this mode of operation, pressure is first applied at or near the leading edge of the substrate and the flexible photomasks and the trailing portions of each photomask wrap partially around the curved surface of each pressure roll. Photosensitive liquid, preferably photohardenable, is then coated on the surface of the photomask or the substrate or both. In certain cases the photosensitive liquid is applied to the photomask while a lower viscosity liquid is applied to the substrate. Preferably, the registration apparatus is oriented so that the general direction is upward, i.e., the substrate movement relative to the pressure rolls and liquid applicators is in upward direction. It is understood that the substrate, pressure rolls or both can move, or one of the above can be in a stationary position. When so oriented, a conditioning or cleaning action of the liquid on the substrate can be achieved since excess liquid can be used and will simply drain into a catching basin carrying any extraneous matter with it. In addition, the area above the pressure rolls, where actinic exposure preferably occurs, can more easily be kept free of unwanted liquid. This process of obtaining alignment of a coated substrate and photomask is obtained without assistance of reduced pressure. It is understood that only one side of the substrate need be coated and a photomask and pressure means need be present only on one side of the substrate.

If the substrate surface is smooth, e.g., with an aluminum plate, a uniform thickness of photosensitive liquid and thereafter bonded hardened material from the photosensitive liquid can be obtained. If the surface of the substrate is not smooth, e.g., having a raised relief pattern such as a printed circuit board, the photosensitive liquid layer will not be uniform due to the raised relief portions. Except for the areas of the substrate containing raised relief portions, the photosensitive liquid layer is a uniform thickness. Also the bonded portions resulting from the photosensitive liquid can likewise be uniform in the same manner.

In the Heiart process, once the photomask has been fixed in register over the substrate coated with the photosensitive liquid interlayer, exposure occurs with any source of radiation actinic to the photosensitive liquid for a prescribed period of time. In a preferred mode of Heiart's operation, the laminated element emerges from the pressure rollers, is stopped and suspended in a fixed upright position and then exposed through a photomask to uniform actinic radiation in the 3000 to 4000 Å or above region. When both sides of the substrate have photosensitive liquid layers, both sides preferably are exposed simultaneously. It is also possible to completely remove the substrate from the registration device and expose it on any suitable exposure unit. The photomasks and carrier remain fixed in registration with the substrate and its photosensitive layer by the action of interfacial or viscous forces induced by the interface liquid. It is understood that both interfacial and viscous forces may be present.

Actinic exposure may induce photoadhesion of the liquid to the photomask depending on the materials from which the photomask is made. To insure easy release of the exposed and hardened liquid, the mask surface can be protected or modified with a thin release layer essentially transparent to actinic radiation. The release layer should have strong adhesion to the mask image surface but have weaker adhesion to the hardened photosensitive liquid. The thickness of the release layer should be minimized, e.g., preferably the thickness of the mask image e.g., about 0.001 inch or less, to insure high resolution of the exposed image. One useful release layer is 0.0005 inch polyethylene terephthalate film adhered to the mask image with an adhesive. Others include various waxes and conventional mold release agents. Desirable features of the photomask include sufficient flexibility to be amenable to the coating/lamination process, dimensional stability in prolonged contact with liquid compositions, chemical stability to liquid compositions ready releasability photopolymer compatibility with release coatings from exposed photopolymer and mechanical durability to stress.

When imaging exposure is complete, removal of the photomask or photomasks takes place, e.g., by peeling from the surface of the exposed photosensitive layer thus releasing the imaged element from registration. The imaged element is then transferred from the coating-registration-exposure apparatus and the photomask-carrier assembly can be returned to its initial position to receive the next substrate if a series of substrates is to be imaged. In a preferred mode of operation, for a series of substrates, the pre-exposure process steps, for the most part, are reversed after the exposure step. Thus the exposed laminated element passes back through the pressure means such as rollers and each photomask is pulled back over its respective pressure roller into a storage area until the hinged area on the carrier is reached. At or near this point the photomask-carrier assembly stops and the imaged substrate is ejected to a device which conveys the substrate from the coating-registration-exposure apparatus. Other means than rollers may be used to apply pressure, e.g., a squeegee. Also the pressure means may be movable and the apparatus holding the registered substrate with the photomask may be stationary. In such modes of operation the apparatus would be substantially ready to accept the next sheet in the series to be exposed. In the preferred operation after exposure, the motion of the imaged substrate is in a downward direction and the pressure rollers are separated to allow the imaged substrate to drop to the conveying means. The photomasks can be stored in any number of ways as they are peeled from the imaged sheet. The preferred mode of storage is on a take-up drum on which the photomask surface remains free of extraneous contact. Alternatively, the photomasks can be stored suspended, or can be wound around the pressure roller itself.

The sheet substrate during the registration and imagewise exposure process may be in any orientation including horizontal or vertical. Preferably the substrate will be in a vertical or substantially vertical plane. In Heiart's process any means can be used to convey the substrate to and from the registration position in the apparatus. For Heiart's preferred mode of operation in an upward-downward direction, the substrate can be conveyed horizontally on its edge by a belt until positioned under the carrier at which point it is elevated into registration contact by a lifting device. After exposure, the imaged sheet is dropped to the conveyor belt which conveys it horizontally on edge out of the apparatus.

The photosensitive liquid which is applied to the photomask or the substrate element or both, may be either negative working or positive working. Negative working liquids would be photohardenable compositions in which the effect of actinic radiation either directly or indirectly hardens or otherwise alters the rheology of exposed image areas. Preferably insolubilization also occurs. Typical photohardening reactions include free-radical chain addition polymerization, crosslinking reactions and dimerization reactions of prepolymers or the like. Such photohardenable compositions are generally disclosed in "Light Sensitive System" by Kosar, John Wiley & Sons, (1965). Positive working liquids would typically be compositions in which the effect of actinic light is to desensitize or inhibit hardening or other rheological change in exposed image areas. Generally, photodesensitization is followed with a hardening process step which hardens unexposed areas. Such a positive working system is described in U.S. 4,162,162 and U.S. 4,269,933.

The photosensitive liquid should possess a viscosity in the unexposed state suitable to form and maintain a continuous layer of uniform thickness between the substrate and the photomask when acted upon by lamination pressure and/or gravitational forces. The optimum liquid viscosity will be influenced by the thickness of the liquid layer, pressure applied in formation of the liquid interlayer between the substrate and photomask, rate of formation of the liquid interlayer, temperature and the orientation of the substrate, e.g., vertical vs. horizontal. The lower viscosity limit is set by that viscosity which provides an acceptably thick and stable photosensitive liquid interlayer between the photomask and substrate under the chosen conditions of lamination pressure, lamination roll durometer (or contact area), and lamination speed, and application requirements. The upper limit is set by the ability of the equipment to deliver a smooth, uniform coating of adequate thickness to the photomask under the same lamination conditions, as well as the ability of the liquid to conform to the circuitry or raised relief if present without massive entrapment of air or bulk low viscosity liquid.

Preferred negative working photosensitive liquids are photopolymerizable liquids containing at least one monomer which preferably is an addition polymerizable ethylenically unsaturated compound having one or more terminal ethylenic groups and a free radical generating addition polymerization initiator system activatable by actinic radiation. Generally, the liquids also contain polymeric binders, filler materials and other monomers either alone or in combination to adjust viscosity and other properties of the photosensitive liquid. The liquids may also contain other components such as dyes, pigments, plasticizers, adhesion aids, thermal inhibitors, etc. which may be required for specific uses of the coated article. Examples of useful monomers, initiators, binders and other components are listed below.

Monomers: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, trimethylolpropane triacrylate, pentaerythritol triacrylate, 2,2-di(p-hydroxyphenyl)-propane diacrylate, pentaerythritol tetraacrylate, 2,2-di(p-hydroxyphenyl)-propane dimethacrylate, triethylene glycol diacrylate, polyoxyethyl-2,2-di(p-hydroxyphenyl)-propane dimethacrylate, di-(3-methacryloxy-2-hydroxypropyl) ether of Bisphenol-A, di-(2-methacryloxyethyl) ether of Bisphenol-A, di-(3-acryloxy-2-hydroxypropyl) ether of Bisphenol-A, di-(2-acryloxyethyl) ether of Bisphenol-A, di-(3-methacryloxy-2-hydroxypropyl) ether of tetrachloro-Bisphenol-A, di-(2-methacryloxyethyl) ether of tetrachloro-Bisphenol-A, di-(3-methacryloxy-2-hydroxypropyl) ether of tetrabromo-Bisphenol-A, di-(2-methacryloxyethyl) ether of tetrabromo-Bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

In addition to the ethylenically unsaturated monomers mentioned above, the photohardenable layer can also contain at least one of the following free-radical initiated, chain-propagating, addition polymerizable, ethylenically unsaturated compounds having a molecular weight of at least 300. These monomers include, preferably, an alkylene or a polyalkylene glycol diacrylate prepared from an alkylene glycol of 2 to 15 carbons or a polyalkylene ether glycol of 1 to 10 ether linkages, and those disclosed in U.S. Patent No. 2,927,022, which is incorporated by reference, e.g., those having a plurality of addition polymerizable ethylenic linkages, particularly when present as terminal linkages, and especially those wherein at least one and preferably most of such linkages are conjugated with a double bonded carbon, including carbon doubly bonded to carbon and to such hetero atoms as nitrogen, oxygen and sulfur. Outstanding are such materials wherein the ethylenically unsaturated groups, especially the vinylidene groups, are conjugated with ester or amide structures.

Initiators: substituted or unsubstituted polynuclear quinones which are compounds having two intracyclic carbon atoms in a conjugated carbocyclic ring system. Suitable such initiators include 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloroanaphthoquinone, 1,4-dimethylanthraquinone, 2,3-dimethylanthraquinone, 2-phenylanthraquinone, 2,3-diphenylanthraquinone, sodium salt of anthraquinone α- sulfonic acid, 3-chloro-2-methylanthraquinone, retenequinone, 7,8,9,10-tetrahydronaphthacenequinone, and 1,2,3,4-tetrahydrobenz(a) anthracene-7,12-dione. Other photoinitiators which are also useful, even though some may be thermally active at temperatures as low as 85° C, are described in Plambeck U.S. Patent No. 2,760,863 and include vincinal ketaldonyl compounds, such as diacetyl, benzil, etc.; α-ketaldonyl alcohols, such as benzoin, pivaloin, etc.; acyloin ethers, e.g., benzoin methyl and ethyl ethers, etc; α-hydrocarbon substituted aromatic acyloins, including α-methylbenzoin, α-allylbenzoin and α-phenylbenzoin. In addition the photoreducible dyes and reducing agents disclosed in U.S. Patent Nos. 2,850,445; 2,875,047; 3,097,096; 3,074,974; 3,097,097; and 3,145,104 as well as dyes of the phenazine, oxazine, and quinone classes may be used. Other suitable polymerization initiators are Michler's ketone, benzophenone 2,4,5-triphenylimidazolyl dimers with hydrogen donors, and mixtures thereof as described in U.S. Patent Nos. 3,427,161; 3,479,185 and 3,549,367. Similarly, the cyclohexadienone compounds of U.S. Serial No. 271,241, filed June 8, 1981 are useful as initiators.

Binders: Binders can be used individually or in combination or in combination with filler material to adjust viscosity of the photosensitive liquid. Typical binders include: polyacrylate and α-alkyl polyacrylate esters, e.g., polymethyl methacrylate and polyethylmethacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrenes; vinylidene chloride copolymers, e.g., vinylidene chloride/acrylonitrile, vinylidene chloride/methacrylate and vinylidene chloride/vinyl acetate copolymers; polyvinyl chloride and copolymers, e.g., polyvinyl chloride/acetate; high molecular weight polyethylene oxides of polyglycols having average molecular weights of 4000 to 1,000,000; epoxides; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; synthetic rubbers, e.g., butadiene/acrylonitrile, acrylonitrile/butadiene (carboxy-modified, e.g., 3%) acrylonitrile/butadiene/styrene, alkyl (1 to 4 carbon atoms) methacrylate/acrylonitrile/butadiene, alkyl (1 to 4 carbon atoms) methacrylate/styrene/acrylonitrile/butadiene interpolymers, 2-chlorobutadiene/1,3-polymers, chlorinated rubber, styrene/butadiene/styrene, styrene/isoprene/styrene block copolymers and other block copolymers described by Holden et al. in U.S. Patent 3,265,765 which is incorporated by reference, n-butyl methacrylate, polyether polyurethane resin, etc., nylons or polyamides, e.g., N-methoxymethyl polyhexamethylene adipamide; cellulose esters, e.g., cellulose acetate, cellulose acetate succinate and cellulose acetate butyrate; cellulose ethers, e.g., methyl cellulose, ethyl cellulose and benzyl cellulose, polycarbonates; polyvinyl acetal, e.g., polyvinyl butyral, polyvinyl formal; polyformaldehydes.

Fillers: If desired the photopolymerizable layers can also contain immiscible polymeric or nonpolymeric organic or inorganic fillers or reinforcing agents which are essentially transparent at wavelengths used for exposure of the photopolymeric material, e.g., the organofilic silicas, bentonites, silica, powdered glass, colloidal carbon as well as various types of dyes and pigments in amounts varying with the desired properties of the photopolymerizable layers. Particulate thickness disclosed in U.S. 3,754,920 and 3,785,817 are useful for this purpose.

Other optional additives include: inhibitors, dyes, pigments, plasticizers, etc.

Suitable thermal polymerization inhibitors include p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitroso dimers, e.g., 1,4,4-tri-methyl-2,3,-diazobicyclo-[3.2.2]-non-2-ene-2,3-dioxide, dinitrobenzene, p-toluquinone and chloranil.

Various dyes may be added to increase the visibility of the image formed. Pigments may also be used in this capacity. Any colorant used, however, should preferably be transparent to the actinic radiation used.

Useful plasticizers may be any of the common plasticizers which are compatible with any polymeric binder used, e.g., dialkyl phthalate, polyethylene glycol, and alkyl phosphates.

Although the photosensitive liquid may be applied to either the photomask or substrate, the liquid may be applied to both the photomask and substrate. Alternatively, a different photosensitive liquid can be concurrently applied to each surface to produce a resulting layer with a gradient of characteristics. In addition, it is not necessary that the different liquids both be photosensitive, two nonphotosensitive liquids or one photosensitive and one nonphotosensitive liquid applied concurrently can combine to form a single photosensitive layer between the substrate and photomask. Furthermore, different systems can be applied to the front and back surfaces of the substrate.

In the present invention it is considered that the prior art liquid coating processes, as exemplified by the Heiart process described above, while generally useful in excluding air from coated structures are still unsatisfactory in certain instances where microbubbles or voids are present in the coated layer or its interface between the substrate or any contacting photomask or protective film. In the production of printed circuit boards and in the use of a liquid coated layer as a solder mask on a substrate surface having a raised circuit relief, the presence of microbubbles or voids becomes critical when the spacing between the raised circuit conducting areas decreases such as with high density circuit boards. When the dimensions of the microbubbles or voids become significant in relationship to the intervening dielectric surface between adjacent conductive circuit lines, the electrical characteristics of the circuit are typically affected leading in some instances to poor mask adhesion and to electrical shorts during the soldering process. In the present invention it has been found that microbubbles or voids present in such high density, liquid, circuits coatings can be eliminated permanently by immersing the coated substrate in a pressurized fluid, e.g., compressed air, for a short duration. Not only are the microbubbles eliminated, e.g., dissolved into the liquid layer, but they do not reappear when the coated substrate is removed from the pressurized fluid even upon standing or further processing. In effect, immersion in a pressurized fluid applies a uniform pressure to all areas and in all directions to the immersed coated substrate without adversely affecting the physical and exposure characteristics of the photopolymerizable coating.

Typically in the practice of this invention, the coated structure after the coating step is then placed in a pressure chamber and the fluid pressure of the chamber raised to at least about 0.3 atmospheres and preferably at least about 3 atmospheres above ambient for a duration of about 1 minute or more. Although the preferred fluid is air or nitrogen, liquids such as water or inert organic materials or solutions thereof may be used provided they do not adversely affect the integrity of the liquid photopolymerizable layer. The fluid pressurization conditions may be adjusted in several ways to insure bubble or void free coated printed circuit structures. For coated soldermasks, structures typically are rendered bubble free by pressurizing in air at room temperature, e.g., 25 to 30° C, at about 5 to 6 atmospheres (i.e. about 74 to 88 psi) above ambient for about 1 minute typically between about 1 minute and about 10 minutes. By increasing the coated substrate temperature, the time duration needed to produce bubble free structures can be reduced below 1 minute or the fluid pressure needed can be reduced. Alternately, the time needed to produce bubble free structures may be increased beyond 1 minute by reducing the fluid pressure applied, e.g., down to about 0.3 atmospheres (about 5 psi) above ambient, and/or the coated substrate temperature below room or ambient temperature. The actual conditions used may be chosen to accommodate the specific method used to pressurize the coated substrate structure and insure the integrity of the bubble free structure before imaging exposure. Fluid pressurization may be carried out in a batch process wherein a number of coated structures are placed in a chamber and fluid pressure raised, or it may be carried out in a sequential, in-line process wherein each coated substrate after it exits the coater, enters a fluid pressurization chamber for a duration needed to insure bubble and void free coated structures.

Although this invention has been described in the context of the Heiart contact exposure process, it is equally applicable to any other liquid application system. Such systems include, but are not limited thereby, the systems of Sullivan U.S. Patents 4,506,004 and 4,591,265 and Losert et al. U.S. Patent 4,230,793 and the like as well as conventional screen coating and printing processes which disclose the use of photopolymerizable and thermally curable liquids. Liquids may be applied to the substrate surface by any prior art or conventional means either as neat liquid or as a solvent solution in which case the solvent is typically removed prior to application of the uniform fluid pressure.

To further illustrate the present invention the following example is provided.

## EXAMPLE

A viscous photopolymerizable liquid is prepared having the following composition by combining the ingredients in a container and stirring with an air-motor driven, propeller-type stirrer until a homogeneous solution is obtained (between 4 and 24 hours, depending on temperature and rate of agitation). Component amounts are given in parts by weight and viscosity is given in poise as determined using a Brookfield viscosometer measured at 25° C at 6 rpm with spindle No. 5.

| Component | A |
|---|---|
| Tripropylene glycol diacrylate | 64 |
| Terpolymer of 56% ethylacrylate, 37% methyl methacrylate, and 7% acrylic acid: mol. wt. ca. 260,000, acid no. ca. 76-85, and TG 37°C | 27.1 |
| Carboset®515 acrylic resin-100% Viscosity 2,000,000 CP, acid No. 63, mol. wt. 7,000, and TG 14°C | 6.5 |
| Tert-butyl anthraquinone | 2 |
| Diethyl hydroxyl amine | 0.2 |
| 2-Mercapto-1,3,4 triazole | 0.2 |
| Liquid viscosity | 857 |

A single side of a printed circuit board is registered, coated with the viscous photopolymerizable liquid at room temperature and imagewise exposed using reverse-roll coating.

The photomask is prepared from a conventional diazo material. The image surface of the photomask is protected by adhering a sheet of Tapecon Emulsion Protection film (Tapecon Inc., Rochester, N.Y.) which is a 0.0005 inch clear polyester film with a 0.0005 inch adhesive layer. Attached in register to the photomask web is a circuit board guide containing registration tabs thereon and having the approximate thickness of the printed circuit board to be imaged.

A printed circuit board having about 0.003 inch high circuit pattern on one side of a 0.062 inch thick fiberglass epoxy board have on a leading edge registration notches which conform to registration tabs of the circuit board guide.

The protected surface of the photomask is coated with a layer of the viscous liquid A by the following procedure. Applicator roll rotating in a clockwise direction picks up liquid from a feeding pan. A metering knife located above the applicator roll surface controls the coating thickness and coating width and with two scrappers at both ends prevents depositing excess liquid banks on the photomask. As the photomask wraps around an idler roll in a clockwise direction the photomask's protected surface skims the coated surface of the rotating applicator roll to transfer the coated liquid to the protected surface.

As the circuit board guide passes through the nip formed by a pressure roll and the photomask wrapped around the idler roll the notches of the printed circuit board are fitted onto the registration tabs of the guide so that the printed circuit board is drawn through the nip in register with the image of the photomask. As the board passes through the nip, the circuit surface contacts the viscous liquid layer and a uniformly coated printed circuit board results by squeezing any excess liquid from the nip. The desired thickness of 0.004 inch of resulting coating is obtained by adjusting the metering knife, the speed at which the coating takes place, and/or the pressure applied by the pressure roll. When the trailing edge of the printed circuit board passes through the nip, the motion is stopped and with the composite element held in place the coated layer is imagewise exposed through the adhered photomask to actinic radiation from a bank of UV fluorescent lamps four inches from the plane of the photomask.

After actinic radiation exposure is complete, pressure roll is raised and the motion of the photomask web is reversed to eject the imaged circuit board. The photohardened image separates completely from the protective surface of the photomask and remains firmly adhered to the circuit board surface. Any unhardened viscous liquid remaining with the photomask surface is recombined with fresh liquid during processing of subsequent boards to be imaged.

When the resulting imaged board is inspected air entrapment in the form of bubbles are observed along circuit lines perpendicular to the path of coating. The process is carried out in the same way except that after the trailing edge of the printed circuit board passes through the nip the motion is continued and the composite element is removed from the nip and placed in a sealed pressure chamber at room temperature (about 68°F or about 20°C). Using compressed air, the chamber is brought up to about 80 psi (about 5.4 atmospheres above ambient) for two minutes. During this time the liquid experiences an increase in pressure equal to that of the chamber pressure. The microbubbles present in the liquid become visibly smaller and eventually diffuse into the liquid. After two minutes the chamber is returned to ambient atmospheric pressure and the composite element returned to its position outside the nip of the rolls where the remaining steps of the exposure process are resumed. When inspected no air entrapped bubbles or voids can be detected along circuit lines even by microscopic examination (200X). Bubble free protective coating is an important criteria for protective masks used during soldering, i.e., as solder masks.

Unhardened liquid remaining on the imaged circuit board is removed in a commercially available ADS-24 processor using 1% NaCO₃ aqueous solution at 95˚ F at a processor speed of 3-4 feet/minute to produce a printed circuit board having a hardened protective coating over the entire circuit pattern except for pad areas corresponding to through-holes in which electrical components are to be soldered.

After development the protective coatings are cured by baking the boards for 1 hour in an oven at 300˚ F followed by two passes through a commercially available U.V. Cure Apparatus at 10 feet/minute. The circuit board is then ready for conventional finishing, fluxing, inserting electrical components and soldering.


## Claims

1. A method of obtaining a substantially bubble free photosensitive liquid layer on a substrate including an interface between the layer and substrate comprising the steps of

(a) applying at least one photosensitive liquid layer to a surface of the substrate to form a coated substrate;

(b) applying elevated pressure of at least 0.3 atmospheres above ambient uniformly to the coated substrate by a pressurized fluid whereby any bubbles entrapped in the liquid layer and interface are eliminated; and

(c) releasing the elevated pressure.

2. The method of claim 1 where the elevated pressure is at least 3 atmospheres above ambient.

3. The method of claim 1 wherein a pressurized chamber is employed which surrounds the substrate.

4. The method of claim 1 wherein the substrate has a raised relief.

5. The method of claim 1 wherein the liquid layer is photopolymerizable.

6. The method of claim 1 wherein the liquid is imagewise exposed to actinic radiation.

7. The method of claim 1 wherein the fluid is a gas.

8. The method of claim 7 wherein the gas is air.

9. The method of claim 1 wherein the fluid is a pressurizing liquid.

10. The method of claim 9 wherein the pressurizing liquid is water.

11. The method of claim 1 wherein the pressurized fluid is applied at ambient temperature.

12. The method of claim 1 wherein the pressurized fluid is applied for a duration between about 1 minute and about 10 minutes.

13. The method of claim 1 wherein the pressurized fluid is applied for a duration of about 1 minute or less.